# EUROPEAN PATENT SPECIFICATION

(11) **EP 0 337 986 B1**
(45) Date of publication and mention of the grant of the patent: **07.04.1993**
(21) Application number: 87903756.2
(22) Date of filing: 17.12.1986
(51) Int. Cl.: H05K 3/40, H05K 3/46

(54) **MULTILAYER CIRCUIT BOARD FABRICATION PROCESS**
VERFAHREN ZUR HERSTELLUNG VON MEHRSCHICHTLEITERPLATTEN
PROCEDE DE FABRICATION DE CARTES DE CIRCUITS MULTICOUCHES

(43) Date of publication of application: 25.10.1989
(73) Proprietor: THE FOXBORO COMPANY, Foxboro, MA 02035 (US)
(72) Inventor: LAKE, Harold, Sharon, MA 02067 (US); GRANDMONT, Paul, E., Franklin, MA 02038 (US)
(74) Representative: Blatchford, William Michael
(86) International application number: US8602710
(87) International publication number: WO8804877

(56) References cited:
- DE-A- 1 937 508
- FR-A- 2 387 568
- GB-A- 2 111 313
- US-A- 3 352 730
- US-A- 3 471 631
- IBM Technical Disclosure Bulletin, vol. 23, no. 10, March 1981, (New York, US), W.D. Grobman: "Multilayer packaging using resist layers", pages 4751 - 4752.
- IBM Technical Disclosure Bulletin, vol. 8, no. 11, April 1966, (New York, US), M.M. Haddad: "Additive multilayer circuit", page 1482.

## Description

The present application is related to our simultaneously filed application EP-A-0 330 020 application Nr 87900544.5 entitled "Method of Patterning Resist for Printed Wiring Board", , and incorporated herein by reference.

This invention relates generally to the manufacture of printed wiring boards and more specifically to the manufacture of multilayered printed wiring boards using generally additive processes.

The ongoing integration and miniaturization of components for electronic circuitry has become a growing challenge to the limits of printed wiring board technology over the last twenty years. Printed circuit boards or printed wiring boards (PWB) as they are more accurately termed, play several key roles. First, the electrical components, such as specially packaged integrated circuits, resistors, etc., are mounted or carried on the surface of the flat usually sturdy card-like board. Thus, the PWB serves as a support for the components. Secondly, using chemically etched or plated conductor patterns on the surface of the board, the PWB forms the desired electrical interconnections between the components. In addition, the PWB can include a metal area serving as a heat sink. As the use of integrated circuits has grown, the higher density of interconnections has necessitated double-sided PWB's in which additional interconnections are made employing conductor patterns on the other side of the board. This trend has been extended to boards of many layers of interconnections termed multilayer PWB's. Connections from layer to layer are typically made by plated through holes.

Conductor patterns are typically formed by photoetching a copper foil clad epoxy fiberglass substrate. A photoresist layer is applied to the copper foil and patterned by exposure to ultraviolet light through a stencil-like film artwork mask. Areas exposed on the photoresist are polymerized. The unpolymerized areas are removed by a chemical solution leaving areas of copper, the desired conductor pattern, underneath the protective barrier of the remaining polymerized photoresist. The exposed copper is then etched away and the remaining photoresist is chemically removed to expose the resulting conductor pattern. There are, of course, many popular variations on this procedure, for example, pattern plating where electroplated copper is added through a patterned resist to form the conductors. However, all of those which require etching of the conductor patterns undercut the conductor pattern to varying degrees because only the top surface is protected from the etchant. Undercutting becomes increasingly troublesome when extremely fine conductor lines are required.

Along with increased circuit integration, surface mount technology (SMT) has greatly accelerated the densification of electronic circuitry offering a reduction in space requirements of up to 70%. Surface mount devices (SMD) are applied directly to the surface of the PWB and soldered using vapor phase, solder reflow or other techniques. Registration of surface mounted integrated circuits having many terminals on fine pitch requires extremely fine resolution for the PWB conductors.

At the same time, electroless plating technology has been rapidly improving. In this system, widely used by the Japanese manufacturers on paper laminate substrates, conductor paths are chemically grown by metal deposition in large plating baths. Improved bath formulations and bath operation systems have recently encouraged the use of electroless plating techniques outside Japan. In one process a catalytic substrate is coated with a photoresist. After patterning the resist, the holes through the resist are filled up with metal using electroless plating. Since conductors are produced by the addition of metal rather than by subtraction, i.e., etching, the process is called "additive". Conductor paths can be produced in this manner to a desired thickness. Generally, electroless plating techniques produce a straight-sided conductor of virgin metal. However, they have required the use of exotic catalytic materials to promote copper deposition and adhesion.

SMD circuitry, however, has become so dense that multilayer PWB's have become the focus of attention and several competing technologies are evolving. Simple stacks of fibreglass epoxy PWB's can be bonded together and interconnections made by drilled plated through holes. Cofired ceramic technology uses another stacking technique. Potted wire matrices have also been proposed. All of these systems have numerous drawbacks. For example, if layers 2 and 3 in a four-layered PWB require an interlayer connection, a through hole has to be made through the entire structure thus consuming "real estate" on layers 1 and 4 which could otherwise be put to use. So-called blind vias with buried interconnections between two or more internal layers are not well accommodated by existing techniques.

The prior art includes the technique of building up multiple layers of conductor patterns by applying consecutive layers of photoprocessable material to act as in situ insulating layers. After each layer is applied, it is photolithographically patterned and developed like a photoresist to create conductor channels and through holes to the subjacent layer, which are then plated with metal. The photoresist material however is left in place. With this technique multilevel vias can be created to interconnect a given layer to any other layer in the structure. See Grobman, IBM Technical Disclosure Bulletin, Vol. 23, No. 10, March 1981, pp. 4751-2.

According to the present invention, a method of fabricating an electrical interconnection board is characterised by: preparing a composite of patternable insulating film clad on one side with a patternable electrolessly platable metal foil, removing portions of the foil to define a conductor pattern on the composite, applying the composite to a pre- existing substrate conductor pattern side down, removing selected portions of the film to form voided apertures revealing the underside of at least a portion of the clad conductor pattern as catalytic plating sites, and electrolessly plating up the voided apertures full of metal.

In preferred techniques in accordance with the invention, it is possible to build multiple layers of conductor circuitry including blind vias and new conductor patterns on a single substrate. A multilayer PWB may be created with blind vias consuming no space in unconnected layers. It is also possible to provide an economical process for making complex multilayer PWB's on a single substrate for SMD's.

In the preferred method, we employ a separately fabricated composite structure consisting of a conductive foil clad insulating film. The conductive side is patterned and etched in a separate process. The composite is then bonded foil pattern side down to a substrate or preexisting multilayer structure and selected areas of the insulating film are removed down to underlying metal sites for electroless plating. All of the apertures patterned into the insulating film are electrolessly plated full of virgin metal flush to the upper surface to form conductors and vias. Additional uniquely patterned composites are applied and plated up as desired to form a multilayer structure of practically unlimited complexity including blind vias.

Advantageously, the insulating film is photoprocessable, preferably a permanent dry film (PDF). The metal foil side, preferably copper, may be photoetched in a conventional manner. Since the foil blocks the exposure energy, the uncured PDF is unaffected by the conductor prepatterning operation which takes place "off the board". After the composite is bonded foil pattern side down to the PWB, the PDF is exposed through a mask and removed where desired to expose either the underside of its own cladding or a subjacent area of metal on the preexisting top surface of the PWB. In the latter case any bonding material may be removed as well. The apertures in the PDF are then plated up electrolessly to form conductors and vias. All the onboard work is accomplished in the additive mode, thus yielding multiplanar conductive paths of continuous virgin metal in finer lines (higher resolution) than reliably attainable by subtractive processes of the prior art. Because electroless plating can begin anew in an area where there was no metal on the multilayer substrate, this technique affords ultimate flexibility in designing circuit patterns independent of the preceding layer. Moreover, the composites can be simultaneously fabricated in parallel assembly systems as subcomponents.

The invention will now be described by way of example with reference to the drawings in which:-
Fig. 1 is a diagrammatic cross-sectional view of the sequential construction of a multilayer circuit board fabricated using the method of the present invention;
Fig. 2 is a diagrammatic cross-sectional view of the composite before and after patterning the foil cladding for use in the construction of the multilayer circuit board shown in step 7 of Fig. 1;
FIGS. 3-6 are cross-sectional diagrammatic views of the multilayer substrate at distinct points between steps 6 and 8 of Fig. 1; and
FIG. 7 is a diagrammatic cross-sectional view of another composite before and after patterning the foil cladding for use in the construction of the multilayer circuit board shown in step 8 of Fig. 1.

The following description discloses multilayer PWB processes in which extremely dense complex independent layers can be built up on a conventional substrate using chemical plating in large continuously running, state of the art plating baths, which accommodate large numbers of circuit boards at one time. The entire process can be as highly automated as desired with composite production proceeding independently. The processes will prove to be not only versatile but also highly economical compared to competitive techniques.

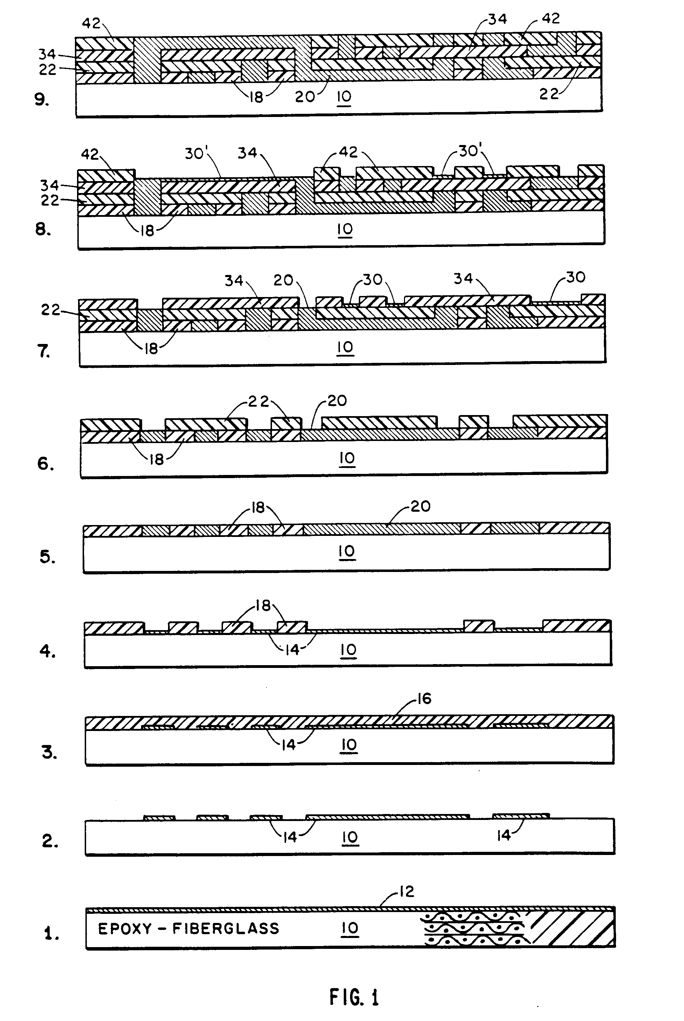

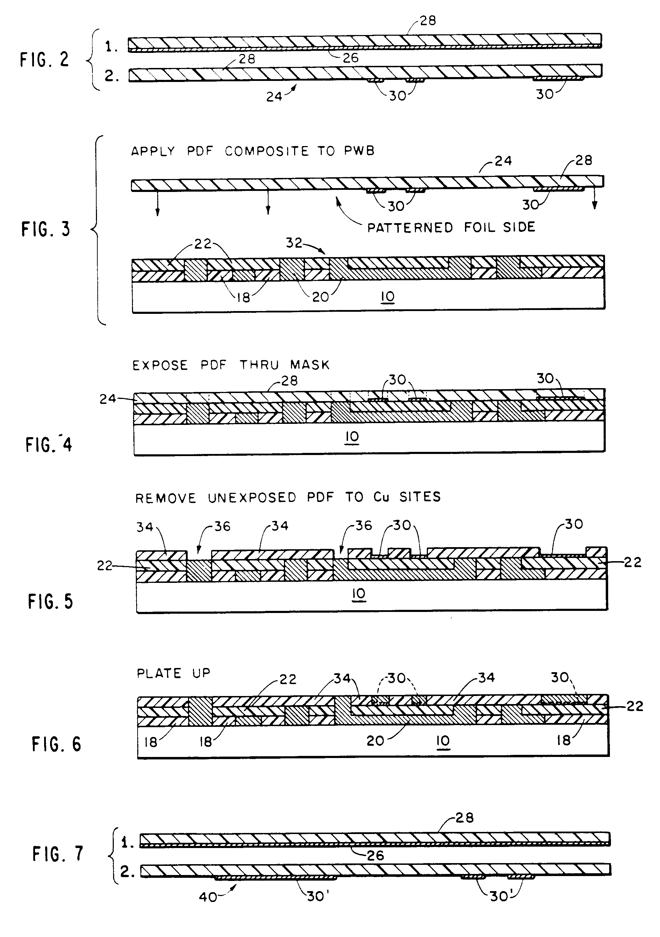

Fig. 1 shows nine phases of construction of a representative multilayer PWB in cross-section. The extent of a given conductor path in the plane of a given layer is omitted for ease of illustration, as the conductor pattern in any given plane can be extremely complex. The metal regions in a given layer exposed in the cross-section as viewed in Fig. 1 may correspond solely to a vertical interconnection spot between two layers or it may be a slice through a conductor running, for example, perpendicular or skewed to the paper in the plane of the layer. Steps 1 through 5 illustrate electroless plating through a permanent dry film to create a single coplanar, conductor layer. Two different composites are added in steps 7 and 8, respectively. The details of the steps leading up to step 8 of Fig. 1 are shown specifically in Figs. 3-6.

In step 1, a substrate 10 is overlaid with a conductive metal foil 12. The substrate may be a sheet fabricated from any insulating material such as synthetic resins, glass, ceramic, ceramic coated metal, paper laminate, cardboard, or fiber. Examples of synthetic resins include phenol-formaldehyde, melamine, and epoxy. The preferred substrate is an epoxy-fiberglass composite.

The conductive metal foil 12 is selected from those metals which have the desired electrical and mechanical properties and chemical and heat resistance. The preferred metal for the foil 12 is copper, typically having a thickness of about one-half to three mils.

In step 2, the metal foil 12 is patterned to form conductive traces. A photoresist (not shown) can be applied to the foil 12, and exposed through a mask. Next, the exposed photoresist is removed and underlying metal etched to leave the desired metal circuit pattern traces 14. The photoresist composition is typically applied in the form of a dry film layer using a conventional lamination or spun- on procedure employing a liquid resist. The resist can be patterned by exposure to ultraviolet (UV) radiation through an artwork mask, or directly with an electron beam, or a laser. Another method of patterning the metal foil is taught in our above- referenced copending application. Because the traces 14 are not intended to constitute finished conductors in and of themselves, the foil 12 is preferably very thin to allow high resolution fine line patterning without undercutting problems which occur in subtractive techniques with thicker layers.

In step 3 of Fig. 1, the conductive pattern 14 formed in the metal foil 12 is overlaid with a photo-processible insulating material 16, preferably a photo-hardenable dielectric film. The insulating material 16 is preferably uncured PDF applied in the form of a dry layer using a lamination procedure.

The preferred PDF material is designated PAR-001, a UV curing polyacrylonitrile in precision thicknesses from E.I. DuPont de Nemours & Co. An undesirable property of this material is that it will not stick well to copper. Thus, a more widely used and commonly available form of PDF contains adhesion promoters for copper, making the material suitable for use as a solder mask, for example, or other types of patterned insulator applications. A disadvantage of the more commonly known form of PDF is that it is impractical to use as a plating mask. In particular, the copper adhesion promotion agent leaches out into the bath and "kills the bath" after an unacceptably short period. PAR-001 PDF, used in the present invention, comes without the copper adhesion promoters and, therefore, may be used as a plating mask without poisoning the bath. However, it does not stick well to copper after curing. The uncured PDF is flexible and slightly tacky and it will adhere temporarily to copper. Uncured PDF laminated to a non copper substrate becomes permanently bonded to the substrate material (in this case epoxy) upon curing.

In step 4, the PDF 16 is patterned by exposure to UV through a mask outlining the desired conductor pattern. The mask will be an identical negative of the photoresist mask of step 2. The exposed areas 18 polymerize, harden and remain, as shown in step 4. The areas between hardened PDF 18 are chemically removed to form voids or apertures through which the underlying copper traces 14 are exposed. The apertures thus expose copper sites for electroless plating. The exposed copper traces serve as catalytic sites for which the copper ions in a bath solution have an affinity. The metal "grows" in thickness by chemical accretion until all of the apertures are filled or "plated up" with pure copper 20 flush with the upper surface as shown in step 5.

In steps 1-5 as shown in Fig. 1, the problem of the PDF plating mask not adhering to copper is not encountered since all of the copper traces 14 in the entire layer are exposed for plating. The only layer to layer interface is between the PDF and the epoxy of the substrate. Thus, after curing the PDF is permanently bonded to the substrate 10 with embedded plated conductors based upon the original copper traces 14 which in turn are themselves bonded to the substrate 10.

As shown in step 6 in Fig. 1, a second PDF layer is applied and processed to leave permanent insulator pattern 22. Note that apertures are formed over pre-existing metal. However, in this case, certain metal conductor areas are not exposed but covered by the PDF 22.

Because there is a copper/PDF layer-to-layer interface in step 6 where a copper conductor is "left off" in the preexisting layer, the adhesion problem must be addressed. As it turns out, PDF will adhere naturally to tin quite well. Accordingly, one technique for enabling PDF adhesion is to cover the exposed surfaces of the metal conductors 20 in step 5 with tin. This can be accomplished by an immersion tin coating step before laminating uncured PDF. Immersion tin coating is used as a flash coat to promote soldering in other processes. The resulting coating is very thin, on the order of several Angstroms, but perfectly suited as a liason between the copper and PDF. Another technique, electroless tin plating, of the pre-existing panel of step 5 would also suffice.

After laminating and patterning the PDF 22, the exposed metal sites 2U need to be plated. Electroless plating of copper, a more noble metal, onto tin being difficult, it is considered preferable to first use a tin stripping bath to remove the ultra-thin exposed tin coating before plating. The exposed copper is then electrolessly plated through the voids in the PDF as in steps 4 and 5. The resulting structure is shown in Fig. 3.

To add new independent circuit conductor patterns where there is no underlying metal, a "composite" 24 shown in Fig. 2 is fabricated in a separate "off-board" procedure. A very thin copper foil cladding layer 26 (half ounce copper foil about half mil thick) is laminated by hot rolling onto one side of an uncured PDF sheet 28. The foil side is then photopatterned to create a thin conductor pattern trace 30. The thinness of the foil enables very fine lines to be etched. The metal foil 26 is photoetched using conventional techniques such as application of a UV photoresist, exposure to actinic UV radiation, stripping of the exposed areas with subsequent etching of the underlying foil, and removal of the unexposed resist. The metal foil 26 acts as a shield for the photosensitive PDF 28 so that the PDF is undisturbed (i.e., left unpolymerized) by the conductor patterning.

Next, the composite 24, still bearing uncured PDF, is bonded foil pattern side down to the top surface 32 of the multilayer substrate, as depicted in Fig. 3. However, first, a double-sided free film adhesive is applied to the pre-existing substrate surface 32. Acrylic film adhesives are available in 1, 2 or 3 mil thicknesses sandwiched between peelable carriers. After bonding the composite to the substrate, the PDF 28 is then photoprocessed to leave hardened insulator pattern 34, as shown in Figs. 4 and 5. Fig. 5 corresponds to step 7 of the entire sequence outlined in Fig. 1. Everywhere copper foil traces are present on the underside of the composite, the overlying PDF is apertured to leave holes and channels to build up vias and conductors. The foil traces are catalytic sites or seeds for plating. Thus, the foil/PDF bond is only temporary and not a problem in the uncured PDF state. In addition, where metal areas on the substrate surface 32 are to be plated through the new layer, they are exposed through apertures in the PDF. The same solvent (e.g., 1, 1, 1 trichloroethane) removes unpolymerized PDF and acrylic film. Then, the copper-bottomed voided apertures are electrolessly plated up, as shown in Fig. 6.

The PDF patterning and plating operations shown in Figs. 5 and 6 are similar to steps 4 and 5 of Fig. 1. However, some of the starting points for plating, i.e., the copper sites 30 shown in Fig. 5 are decidedly different from the pre-existing copper sites used exclusively in steps 4 and 6, for example, of Fig. 1. Sites 30 in Fig. 5 are indeed the underside of the foil cladding layer 26 (Fig. 2) in which the conductor trace pattern 30 was formed. These extremely thin foil conductors 30 on the composite form new sites for electroless plating in regions where there is no underlying metal in the preceding layer. The hardened PDF insulator layer 22 and acrylic adhesive film lie beneath the foil sites 30. Note that the PDF of the composite may be removed in areas 36 not coinciding with its own clad conductor pattern so as to plate connections to the subjacent layer. Thus, the use of the composite allows flexibility in plating up over existing or new metal. In addition, some conductors exposed in surface 32 of the pre-existing substrate will be left off, i.e., not connected electrically to the new layer. Thus, the acrylic film adhesive layer between composte and substrate solves two different problems: it not only bonds the traces on the bottom of the composite to the underlying cured PDF on surface 32 of the substrate, but also bonds the exposed copper conductors being left off to the uncured PDF of the composite.

Note that, while the same acrylic adhesive film technique could be used in steps 1-5 of Fig. 1 instead of tin coating the conductive pattern, it is good to minimize the number of adhesive film layers because they may not be as temperature stable as the PDF. Thus, where PDF alone (i.e., non-composite) is added, tin coating of underlying copper is preferred.

Fig. 6 corresponds to step 8 of Fig. 1 before the addition of the next layer. After the process shown in Fig. 6 in which the apertures are plated flush with the top surface of the growing multilayer structure, either PDF alone (like steps 3-5) as in step 6 of Fig. 1 or another composite as in Fig. 7 in step 7 of Fig. 1 can be added. Fig. 7 shows a second composite 40 on which a distinct conductor pattern 30' is formed in a manner identical to that of Fig. 2. The composite 40 is bonded foil side down and the PDF is photoprocessed as desired to leave the configuration shown in step 8 of Fig. 1 using a procedure identical to that described above and illustrated in Figs. 3, 4 and 5. The remaining hardened PDF 42 leaves apertures over old and new metal, the new metal being provided by the clad pattern 30'. The apertures are plated up from the copper sites flush with the top surface as shown in step 9 of Fig. 1 to complete the multilayer structure in this illustration. Surface mounted components would be attached directly to the top conductor surface. A solder mask (not shown) could be applied to protect surface conductors, leaving only those exposed sites necessary for component attachment.

Steps 3 to 5 and 7 to 9 of Fig. 1 may be alternated or repeated as necessary to create a particular multilayer PWB.

Although the composites are described as applied to a pre-existing multilayer substrate, the composite could just as easily be applied as the first circuit layer on an insulating substrate such as epoxy-glass board. Additional composites and insulating layers could then be added as desired.

A key feature of this method is the flexibility of being able to design any conductive metal pattern 30 and 30' without the difficulties of working directly on top of the multilayer structure. For example, development methods may be used which are incompatible with the already constructed multilayered substrate. Also, a number of circuits may be prepared simultaneously or in advance to minimize the actual assembly time.

The process which utilizes a photo-processible insulating material and patterned conductive foil composite has the following additional advantages over the prior art methods: (1) the patterned copper foil forms a conductive circuit which can be directly applied to the multilayer board without further plating or etching; (2) no embedded conductor wires are required; (3) the composite forms vertical connections and blind vias without drilling and plating of holes in multiple insulating layers, and (4) the on-board process is fully additive, with improved conductor resolution, delineation and shape. The resulting conductive paths are formed of continuous virgin metal. The reduction of processing steps and the ability to metallize substrate conductors simply by immersion in an electroless plating tank allows additive circuit boards to be made in higher volumes with batch processing at lower costs than with conventional processes. Further, electroless plating provides a means for fabricating higher density boards with deep, small diameter vias (high aspect ratio), unlike with semi-additive processes or processes utilizing electroplating techniques.

Other variations and modifications of this method for producing multilayer circuit boards will occur to those skilled in the art from the foregoing detailed description and accompanying drawings without departing from the principles and spirit of the invention. For example, although the method of Fig. 1 is illustrated in the fabrication of single-sided multilayer PWB, it is possible and no doubt preferable in many instances to apply the method of Fig. 1 in the manufacture of a double-sided board by layering both sides at once. In addition, while the method of Fig. 1 emphasises the preference for photoprocessable insulator, a non-photoprocessable insulating layer can be used for the preparation of the composite 24 in Fig. 2 of the method of Fig. 1 by cutting apertures in the insulator directly by a laser beam, for example, which would be reflected by the underlying metal sites in the existing multilayer PWB structure. The disadvantage is that it is not a "batch process", but requires directed energy.

## Claims

1. A method of fabricating an electrical interconnection board, characterised by:
preparing a composite of patternable insulating film clad on one side with a patternable electrolessly platable metal foil,
removing portions of the foil to define a conductor pattern on the composite,
applying the composite to a pre-existing substrate conductor pattern side down,
removing selected portions of the film to form voided apertures revealing the underside of at least a portion of the clad conductor pattern as catalytic plating sites, and
electrolessly plating up the voided apertures full of metal.

2. A method according to claim 1, further characterised by repeating the recited steps to construct multiple composite-based layers.

3. A method according to claim 1 or claim 2, characterised in that the insulating film is photoprocessable and the removing step for the film is accomplished by photoprocessing the film.

4. A method according to claim 3, characterised in that the insulating film is an uncured permanent dry film (PDF).

5. A method according to claim 4, characterised in that the metal is copper and the PDF is substantially free of copper adhesion promotion agents to avoid poisoning the bath used in the electroless plating step.

6. A method according to claim 5, characterised in that the composite applying step includes applying an adhesive layer between the substrate and the composite.

7. A method according to claim 6, characterised in that the adhesive layer is formed of a material which is removable along with portions of the film to form the voided apertures.

8. A method according to claim 1, characterised in that the foil removing step includes using a photoresist to define the conductor pattern.

9. A method according to claim 1, further characterised by first preparing a substrate having metal conductors exposed on the surface of the substrate, the step of removing selected portions of the film revealing the underside of all the said clad foil pattern and at least some sites on the metal conductors on the substrate surface.

10. A method according to claim 9, characterised in that the applying step includes bonding said composite to the substrate with a layer of adhesive material.

## Patentansprüche

1. Verfahren zur Herstellung einer elektrischen Leiterplatte, gekennzeichnet durch:
Bereiten eines Verbundelements aus eine Musterausbildung gestattendem isolierendem Film, der an einer Seite mit einer eine Musterausbildung gestattenden, stromlos plattierbaren Metallfolie überzogen ist,
Entfernen von Teilen der Folie, um ein Leitermuster auf dem Verbundelement zu definieren,
Anbringen des Verbundelements an einem bereits existierenden Substrat, mit der Seite des Leitermusters nach unten,
Entfernen ausgewählter Teile des Films zur Bildung freier Öffnungen, die die Unterseite zumindest eines Teiles des den Überzug bildenden Leitermusters als katalytische Plattierungsareale freilegen, und
stromloses Aufplattieren der freien Öffnungen zur Auffüllung derselben mit Metall.

2. Verfahren nach Anspruch 1, außerdem gekennzeichnet durch Wiederholung der aufgeführten Schritte zum Aufbau von Mehrfachschichten auf Verbundelementenbasis.

3. Verfahren nach Anspruch 1 oder 2, dadurch gekennzeichnet, daß der isolierende Film fotobearbeitbar ist und der für den Film vorgesehene Schritt des Entfernens durchgeführt wird, indem der Film fotobearbeitet wird.

4. Verfahren nach Anspruch 3, dadurch gekennzeichnet, daß der isolierende Film ein ungehärteter Dauertrockenfilm (PDF) ist.

5. Verfahren nach Anspruch 4, dadurch gekennzeichnet, daß das Metall Kupfer ist und der PDF im wesentlichen frei von die Adhäsion an Kupfer fördernden Mitteln ist, um ein Vergiften des bei dem Schritt des stromlosen Plattierens benutzten Bades zu vermeiden.

6. Verfahren nach Anspruch 5, dadurch gekennzeichnet, daß der Schritt des Anbringens des Verbundelements das Anbringen einer Klebstoffschicht zwischen dem Substrat und dem Verbundelement beinhaltet.

7. Verfahren nach Anspruch 6, dadurch gekennzeichnet, daß die Klebstoffschicht durch ein Material gebildet wird, das zusammen mit Teilen des Films entfernbar ist, um die freien Öffnungen zu bilden.

8. Verfahren nach Anspruch 1, dadurch gekennzeichnet, daß der für die Folie vorgesehene Schritt des Entfernens die Verwendung eines Photoresist einschließt, um das Leitermuster zu definieren.

9. Verfahren nach Anspruch 1, außerdem gekennzeichnet durch zunächst erfolgendes Bereiten eines Substrats mit an der Oberfläche des Substrates freiliegenden metallischen Leitern, wobei der Schritt des Entfernens ausgewählter Teile der Folie die Unterseite des ganzen, den Überzug bildenden, genannten Musters der Folie und zumindest einige Areale an den metallischen Leitern an der Oberfläche des Substrats freilegt.

10. Verfahren nach Anspruch 9, dadurch gekennzeichnet, daß der Schritt des Anbringens das Verbinden des genannten Verbundelements mit dem Substrat mit einer Schicht aus klebendem Material beinhaltet.

## Revendications

1. Procédé de fabrication d'une plaque d'interconnexion électrique, caractérisé par :
la préparation d'un produit composite formé d'une pellicule isolante pouvant être structurée, dont une face est recouverte par une feuille métallique pouvant être structurée et apte à être plaquée d'une manière autocatalytique,
le retrait de parties de la feuille pour définir une structure de conducteurs sur le produit composite,
l'application du produit composite, avec sa face portant la structure de conducteurs tournée vers le bas, sur un substrat préexistant,
le retrait de parties choisies de la pellicule pour former des ouvertures évidées mettant à nu la face inférieure d'au moins une partie de la structure de conducteurs déposée, en tant que sites de placage catalytique, et
le placage autocatalytique des ouvertures évidées, de manière à les remplir complètement de métal.

2. Procédé selon la revendication 1, caractérisé en outre par la répétition des étapes indiquées pour former de multiples couches basées sur le produit composite.

3. Procédé selon la revendication 1 ou 2, caractérisé en ce que la pellicule isolante peut être traitée par voie photochimique et que l'étape d'élimination de la pellicule est mise en oeuvre par traitement photochimique de cette dernière.

4. Procédé selon la revendication 3, caractérisé en ce que la pellicule isolante est une pellicule sèche permanente (PDF) non durcie.

5. Procédé selon la revendication 4, caractérisé en ce que le métal est du cuivre et la pellicule PDF est sensiblement exempte d'agents favorisant l'adhérence du cuivre afin d'éviter un empoisonnement du bain utilisé lors de l'étape de placage autocatalytique.

6. Procédé selon la revendication 5, caractérisé en ce que l'étape d'application du produit composite comprend l'application d'une couche adhésive entre le substrat et le produit composite.

7. Procédé selon la revendication 6, caractérisé en ce que la couche adhésive est formée d'un matériau qui peut être retiré avec des parties de la pellicule pour former les ouvertures évidées.

8. Procédé selon la revendication 1, caractérisé en ce que l'étape d'élimination de la feuille inclut l'utilisation d'une résine photosensible pour définir la structure des conducteurs.

9. Procédé selon la revendication 1, caractérisé en outre tout d'abord par la préparation d'un substrat possédant des conducteurs métalliques à nu sur sa surface, l'étape d'élimination de parties sélectionnées de la pellicule, qui dégage la face inférieure de l'ensemble de la structure de la feuille déposée et au moins certains sites sur les conducteurs métalliques situés sur la surface du substrat.

10. Procédé selon la revendication 9, caractérisé en ce que l'étape d'application inclut le collage dudit produit composite sur le substrat à l'aide d'une couche de substance adhésive.
